# EUROPÄISCHE PATENTSCHRIFT

(11) **EP 1 101 125 B1**
(45) Veröffentlichungstag und Bekanntmachung des Hinweises auf die Patenterteilung: **20.03.2002**
(21) Anmeldenummer: 99940034.4
(22) Anmeldetag: 22.07.1999
(51) Int. Cl.: G01R 33/09

(54) **VERFAHREN ZUR AUSWERTUNG VON SIGNALEN MAGNETORESISTIVER SENSOREN**
METHOD FOR EVALUATING SIGNALS OF MAGNETORESISTIVE SENSORS
PROCEDE POUR EVALUER DES SIGNAUX DE DETECTEURS MAGNETORESISTIFS

(30) Priorität: 29.07.1998 DE 19834153
(43) Veröffentlichungstag der Anmeldung: 23.05.2001
(73) Patentinhaber: LUST ANTRIEBSTECHNIK GmbH, D-35631 Lahnau (DE)
(72) Erfinder: KUNZE, Jürgen, D-35585 Wetzlar (DE); SCHEPP, Gunther, D-35428 Langgöns-Oberkleen (DE); DETTMANN, Fritz, D-35764 Sinn (DE); LOREIT, Uwe, D-35580 Wetzlar (DE)
(74) Vertreter: Knefel, Cordula, Dipl.-Phys.
(86) Internationale Anmeldenummer: EP9905233
(87) Internationale Veröffentlichungsnummer: WO0007033

(56) Entgegenhaltungen:
- WO-A-98/07165
- US-A- 4 596 950
- US-A- 5 351 005
- US-A- 5 747 997
- PATENT ABSTRACTS OF JAPAN vol. 016, no. 516 (P-1443), 23. Oktober 1992 (1992-10-23) & JP 04 191685 A (FUJITSU LTD), 9. Juli 1992 (1992-07-09)

## Beschreibung

Die Erfindung betrifft ein Verfahren und einige Vorrichtungen zur Durchführung desselben zur Auswertung von Signalen magnetoresistiver Sensoren, bei denen zur Eliminierung eines zum Nulloffset proportionalen Störsignales die Magnetisierung der magnetoresistiven Widerstandsstreifen periodisch durch Flipstromimpulse durch eine integrierte Flipleitung oder eine externe Flipspule abwechselnd in positiver und negativer Richtung eingestellt oder lediglich moduliert wird. Dabei kann der magnetoresistive Sensor zur hochauflösenden Messung eines Magnetfeldes oder eines Magnetfeldgradienten oder darauf zurückführbarer Größen, wie zum Beispiel zur potentialfreien Strommessung, eingesetzt werden.

Magnetfeldmeßgeräte, die solche Verfahren mit dem Ziel einsetzen, die durch Ungleichheit der Widerstände und deren Temperaturabhängigkeit bedingte Offsetspannung in magnetoresistiven Sensorbrücken vom magnetfeldproportionalen Sensorsignal zu trennen, sind bereits bekannt. So wird in der. Offenlegungsschrift DE 34 42 278 ein Magnetfeldmeßgerät beschrieben, das einen Magnetfeldsensor mit vier aus mgnetoresistiven Schichtstreifen mit Barberpolstrukturen bestehenden Sensorelementen enthält, die als Wheatstonesche Brücke geschaltet sind und von einer Gleichstromquelle gespeist werden. Bedingt durch Toleranzen in der Fertigung der magnetoresistiven Schichtstreifen sind nicht alle vier Brückenwiderstände vollständig gleich, und es tritt am Ausgang der Sensorbrücke ohne Vorhandensein eines zu messenden Magnetfeldes die durch einen Gleichspannungswert gegebene Offsetspannung auf. Alle magnetoresistiven Schichtstreifen des Sensors weisen jeweils zu demselben Zeitpunkt dieselbe magnetische Vorzugsrichtung auf, die durch die Richtung ihrer jeweiligen Magnetisierung gegeben ist. In der Nähe der Sensorelemente ist eine Magnetisierungsspute angeordnet, die von einem Stromimpulsgenerator mit kurzen, abwechselnd positiven und negativen Stromimpulsen gespeist wird, die in der Magnetisierungsspule ein magnetisches Wechselfeld erzeugen, welches die magnetoresistiven Schichtstreifen im Takt der Flipstromimpulse ummagnetisiert. Bei Anliegen eines zu messenden Magnetfeldes entsteht am Nullzweig der Sensorbrücke zusätzlich zu der erwähnten Offsetgleichspannung eine Wechselspannung. Diese kann von einem durch den Stromimpulsgenerator gesteuerten phasenempfindlichen Gleichrichter angezeigt werden, der am Ausgang zur Beseitigung der als Wechselspannungsanteil enthaltenen Offsetspannung einen Integrator aufweist, dessen Ausgangsspannung dem am Magnetfeldsensor anliegenden Magnetfeld proportional ist, solange dieses im Linearitätsbereich des Magnetfeldsensors liegt.

Ein wesentlicher Nachteil des beschriebenen Meßverfahrens besteht darin, daß die Messung von Magnetfeldern nur noch mit einer maximalen Bandbreite erfolgen kann, die bei einem Hundertstel bis zu einem Zehntel der Frequenz der Flipstromimpulse liegt, da die als Wechselanteil im Signal nach dem phasenempfindlichen Gleichrichter vorhandene Offsetspannung der Sensorbrücke sonst mit einem zu großen Anteil vorhanden ist. Schnelle Feldänderungen können also nicht nachgewiesen werden. Ein zweiter Nachteil des Meßverfahrens ist durch den begrenzten Linearitätsbereich der Kennlinie der Sensorbrücke und durch die Temperaturabhängigkeit der Steigung der Kennlinie sowie deren Abhängigkeit von der in der Längsrichtung der magnetoresistiven Schichtstreifen wirkenden Magnetfeldkomponente bedingt. Das führt dazu, daß die Proportionalität der Ausgangsspannung der beschriebenen Meßschaltung zur Feldstärke der gemessenen Magnetfeldkomponente nur in einem stark eingeschränkten Feldstärkebereich und nur bei konstanter Temperatur und konstanter Magnetfeldkomponente in Streifenlängsrichtung gegeben ist.

Dieser zweite Nachteil ist bereits in einem verbesserten Meßverfahren nach der Patentschrift US 5, 351, 005 nicht mehr vorhanden. In der angegebenen Schaltung wird durch phasenempfindliche Gleichrichtung ein Strom erzeugt, der der zu messenden Magnetfeldstärke proportional ist. Dieser Strom wird in eine Kompensationsspule eingespeist, in der sich die magnetoresistive Sensorbrücke befindet und erzeugt hier ein Magnetfeld. Die Schaltung regelt diesen Strom auf einen Wert, der in der Spule ein Magnetfeld erzeugt, welches das von außen angelegte Magnetfeld gerade aufhebt. Die magnetoresistive Sensorbrücke wirkt hier nur noch als Nullinstrument. Deshalb spielen Nichtlinearitäten der Kennlinie und ihre Abhängigkeit von der Temperatur und der entsprechenden Magnetfeldkomponente hier auch keine Rolle mehr. Das Ausgangssignal der Schaltung wird z. B. aus einem Spannungsabfall gewonnen, den der Strom durch die Kompensationsspule an einem festen Widerstand erzeugt. Zwei "Sample and Hold"-Verstärker werden abwechselnd, gesteuert im Takt des Flipstromgenerators, zur Messung des jeweiligen Spannungsabfalls für die beiden Magnetisierungsrichtungen im magnetoresistiven Sensor benutzt. Die von einem Tiefpaßverstärker gebildete Differenz der beiden Spannungen der "Sample and Hold"-Verstärker enthält nur noch den magnetfeldproportionalen Anteil des Signals, während der zum Offset der Sensorbrücke proportionale Anteil durch die Differenzbildung herausfällt. Die Bandbreite, mit der auf der Basis der hier beschriebenen Schaltung Magnetfelder gemessen werden können, wird im wesentlichen durch die Bandbreite des Tiefpaßverstärkers bestimmt. Im günstigsten Fall kann eine Bandbreite von der halben Frequenz der Flipstromimpulse erreicht werden, denn für das Erhalten des richtigen Magnetfeldwertes müssen beide "Sample and Hold"-Verstärker mindestens je einen Meßwert aufgenommen haben.

Im "Data Handbook SC 17" (1997) von Philips Semiconductors, Seite 36, ist eine weitere Schaltung zur Eliminierung des Brückenoffsets aus dem Sensorsignal angegeben. Hier wird das Brückensignal zunächst einem Differenzverstärker zugeführt. Der Gleichspannungsanteil des Signals nach dem Differenzverstärker, der die Offsetspannung der Sensorbrücke und des Differenzverstärkers enthält, wird über ein Tiefpaßfilter auf den Eingang des Differenzverstärkers negativ zurückgekoppelt und damit auf Null geregelt. Der dem zu messenden Magnetfeld proportionale Wechselspannungsanteil des Signals wird über einen gesteuerten Verstärker gleichgerichtet. Das gleichgerichtete Signal wird als Strom in eine Kompensationsspule eingespeist und hebt hier das zu messende Magnetfeld auf. Da die sprungartige Änderung der Eingangsspannung des gesteuerten Verstärkers um die Regelabweichung zu Spannungsspitzen an dessen Ausgang führt, wird ein Filter nachgeschaltet. Damit ist auch hier die Messüng des Magnetfeldes nur mit einer Bandbreite möglich, die weit unter der Flipfrequenz liegt.

Die bisher angegebenen bekannten Verfahren zur Eliminierung des Nulloffset der magnetoresistiven Brückenschaltungen betreffen alle solche Brücken, deren Widerstandsstreifen mit Barber Pole Strukturen versehen sind und deren Magnetisierung in positiver oder negativer Längsrichtung mittels eines Gleich- oder Impulsfeldes einstellbar sind. Die Richtung der dabei verwendeten Magnetfelder stimmt dabei im wesentlichen mit der leichten Richtung der magnetoresistiven Widerstandsstreifen überein. Die Richtung des zu messenden Feldes liegt senkrecht dazu in schwerer Richtung der Streifen. In der Patentschrift US-A-4,596,950 wird jedoch eine magnetoresistive Brücke beschrieben, die aus vier Dünnschichtstreifen aus anisotrop magnetoresistivem Material besteht, die keine Barber Pole Struktur tragen. Der Widerstand solcher Dünnschichtstreifen hängt quadratisch von der Magnetfeldstärke in schwerer Richtung ab. Ohne Anliegen eines Magnetfeldes ist deshalb eine Feldempfindlichkeit bei kleinen Feldstärken nicht vorhanden, wenn nicht ein Hilfsmagnetfeld zur Arbeitspunkteinstellung in schwerer Richtung an die Dünnschichtstreifen angelegt wird. Dieses Hilfsmagnetfeld wird entsprechend der Patentschrift US-A-4,596,950 durch den Betriebsstrom der Brücke mit erzeugt, da die die Brückenwiderstände bildenden Dünnschichtstreifen entweder paarweise übereinander angeordnet sind oder eine magnetfelderzeugende Dünnschichtleitung, die vom Betriebsstrom durchflossen wird, über den magnetoresistiven Dünnschichtstreifen vorhanden ist. In der Patentschrift wird vorgeschlagen, die Brückenspannung einem Wechselspannungsverstärker zuzuführen und dessen Ausgang auf einen Tiefpaß zu geben, dessen Ausgangssignal auf einen Verstärker übertragen wird und dessen Ausgangsstrom in einer Spule ein Magnetfeld erzeugt, welches das zu messende Feld kompensiert. Dazu muß der Betriebsstrom der Brücke zeitlich periodisch umgepolt werden. Als Ausgangssignal der Meßanordnung wird der durch den Kompensationsstrom hervorgerufene Spannungsabfall an einem bekannten Widerstand benutzt. Durch die gleichzeitige Umschaltung der Betriebsstromrichtung und des dadurch eingestellten Arbeitspunktes der magnetoresistiven. Dünnschichtstreifen ist das Ausgangssignal vom Offset der Brücke nicht abhängig.

Die hier vorgeschlagene Meßanordnung hat noch folgende Nachteile: Die Messung ist nur bis zu einer oberen Frequenzgrenze möglich, die unterhalb der Grenzfrequenz des Tiefpasses liegt. Diese kann jedoch höchstens bei etwa einem Zehntel der Frequenz liegen, mit der der Betriebsstrom der Brücke umgepolt wird. Weiterhin werden für die Arbeitspunkteinstellung der magnetoresistiven Dünnschichtstreifen dauernd anliegende Felder im Bereich von etwa 1 kA/m benötigt. Felder dieser Größe sind in den beschriebenen Anordnungen nur mit Strömen von einigen 10 mA machbar. Da die umgesetzte Verlustleistung einer Brücke auf maximal etwa 0,1 W begrenzt werden muß, sind nur geringe Brückenwiderstände einsetzbar. Damit sind auch die Brückenspannungen begrenzt, und zwar auf wenige Zehntel Volt. Dadurch wird die Meßempfindlichkeit stark eingeschränkt, und zwar auf etwa ein Hundertstel des Wertes einer magnetoresistiven Brücke ohne Korrektur des Offsetspannungsfehlers. Da für den Einsatz jedoch das Verhältnis von Empfindlichkeit zum Offsetfehler möglichst groß sein muß, ist hier nur noch eine geringe Verbesserung zu erwarten.

Zum Vergleich mit den oben angegebenen Meßverfahren, die die Magnetisierungsrichtung von magnetoresistiven Dünnschichtstreifen mit Barber Pole Struktur mit Magnetfeldimpulsen wechselnden Vorzeichens in leichter Richtung umschalten, ist anzumerken, daß die Magnetfeldimpulse nur während einer Dauer von weniger als einer Mikrosekunde anliegen müssen. Damit ist eine Einschränkung empfindlichkeitsbedingender Parameter durch die elektrische Verlustleistung hier nicht gegeben.

Aufgabe der Erfindung ist es nun, ein Verfahren zur Signalauswertung mit Unterdrückung des Brückenoffsets an magnetoresistiven Sensorelementen, die eine Sensorelementanordnung, wie beispielsweise eine Sensorbrücke, bilden können, anzugeben. Bei dem erfindungsgemäßen Verfahren wird die Magnetisierungsrichtung in den die Widerstände bildenden magnetoresistiven Sensorelementen durch Anlegen eines Wechselfeldes periodisch umgeschaltet, wobei die Bandbreite des Auswerteverfahrens nicht durch die zur Ummagnetisierung eingesetzte Flipfrequenz begrenzt ist.

Diese Aufgabe wird durch das im Hauptanspruch beschriebene und in den Unteransprüchen weiter spezifisch ausgebildete Verfahren gelöst.

Durch die wiederholte Umkehr oder Modulation der Magnetisierungsrichtung in den angesprochenen magnetoresistiven Sensorelementen, die mit Barber Pole Strukturen versehen sein können, durch ein magnetisches Impulsfeld abwechselnder Richtung oder wechselnder Intensität und durch die im Takt des magnetischen Impulsfeldes umgeschaltete Betriebsspannung der Sensorelemente kommt es an deren Ausgang zu einem Signal, das dem auf die Sensorelemente wirkenden Magnetfeld oder Magnetfeldgradienten proportional ist und das von einem Wechselanteil mit dem Offsetsignal als Amplitude überlagert ist. Dieses Ausgangssignal wird einem Differenzverstärker zugeführt, und bei einem einfachen Ausführungsbeispiel - beispielsweise einer als Wheatstonebrücke ausgeführten magnetoresistiven Sensorelementanordnung - liegt am Nullzweig der Brücke bereits die Ausgangsspannung der Schaltung als Meßsignal vor. Damit dieses Ausgangssignal den durch den Offset bedingten Wechselanteil nicht mehr enthält, wird dieser gleichgerichtet und phasenrichtig auf den jeweiligen Eingang des Differenzverstärkers zurückgekoppelt, so daß er vom Differenzverstärker minimiert, theoretisch sogar auf Null geregelt werden kann. Dazu gelangt das Signal vom Ausgang des Differenzverstärkers über einen im Takt des magnetischen Impulsfeldes gesteuerten Modulator oder Umschalter auf einen Tiefpaß und .über einen Verstärker auf einen weiteren im Takt des magnetischen Impulsfeldes gesteuerten Modulator oder Umschalter, der die Verbindung mit dem jeweiligen Eingang des Differenzverstärkers herstellt.

Der Tiefpaß in der Rückkopplung kann eine geringe Grenzfrequenz haben, da Offsetänderungen in den Sensorelementen nur relativ langsam erfolgen - beispielsweise auf Grund von Temperaturänderungen - und durch den Regelkreis dann trotzdem aus dem Ausgangssignal entfernt werden. Im eigentlichen Signalweg sind keine frequenzbegrenzenden Stufen vorgesehen. Damit werden zu messende Magnetfeldänderungen mit hoher Bandbreite als Änderung der Ausgangsspannung übertragen. Diese Bandbreite ist nicht durch die Taktfrequenz des magnetischen Impulsfeldes, das zur Modulation oder Umkehr der Magnetisierungsrichtung der magnetoresistiven Sensorelemente dient, begrenzt und liegt wesentlich größer als diese. Die maximal übertragbare Frequenz wird dadurch begrenzt, daß die Magnetfeldimpulse zur beschriebenen Magnetisierung der magnetoresistiven Schichtstreifen eine bestimmte Dauer nicht unterschreiten können, und daß während der Änderung der Magnetisierung eine zum einwirkenden Magnetfeld proportionale Widerstandsänderung der magnetoresistiven Schichtstreifen nicht gegeben ist.

In einer speziellen, vorteilhaften Ausführungsform des erfindungsgemäßen Verfahrens wird aus der Ausgangsspannung des Differenzverstärkers ein proportionaler Strom gebildet und in eine in der Nähe der Sensorbrücke befindliche Spule eingespeist. Das Magnetfeld dieses Stromes ist am Ort der Sensorbrücke dem zu messenden Magnetfeld entgegengerichtet. Der Strom wird von der Schaltung auf einen Wert geregelt, der zur Aufhebung des Magnetfeldes am Ort der Sensorbrücke führt. Der Offsetspannungsanteil am Ausgang des Differenzverstärkers wird dabei, wie oben beschrieben, durch Gleichrichtung und phasenrichtige Rückkopplung auf den Eingang des Verstärkers auf Null geregelt. Das Ausgangssignal der Schaltung ist hier der Spannungsabfall, den der Strom über einem bekannten Widerstand erzeugt. Dieser Spannungsabfall ist unabhängig von der Temperatur und vom Betrag des zu messenden Feldes zu diesem proportional, und zwar innerhalb einer Bandbreite, die nicht durch die Taktfrequenz des magnetischen Impulsfeldes begrenzt wird, sondern entweder durch die Dauer der Ummagnetisierungsimpulse oder durch die Zeitkonstante des Regelkreises für die Kompensation des Eingangssignales.

In einer weiteren Ausführungsform der Erfindung wird die Taktfrequenz, mit der die Umkehr oder Modulation der Magnetisierung der magnetoresistiven Sensorelemente erfolgt und mit der die Umschalter oder Modulatoren gesteuert werden, zeitlich periodisch variiert. Dadurch wird vermieden, daß es über eine längere Zeitdauer zu einer Übereinstimmung der Frequenz des auf die Sensorbrücke einwirkendenden Magnetfeldes und der Taktfrequenz kommen kann. Wäre letzteres der Fall und stimmt darüber hinaus der Zeitpunkt der jeweiligen Vorzeichenänderung des Magnetfeldes mit dem Zeitpunkt des Ummagnetisierungsimpulses überein, so überlagern sich die vom Magnetfeld erzeugten Spannungssignale und die von der Offsetspannung in gleicher Phase erzeugten Spannungssignale. Damit würde dann durch die Rückkopplung am Differenzverstärker nicht nur der Offsetanteil, sondern auch der durch das Eingangssignal hervorgerufene Signalanteil auf Null geregelt werden, und eine Messung wäre nicht mehr möglich. Wird die Taktfrequenz der Ummagnetisierung jedoch innerhalb einer Periodendauer variiert, die kürzer ist als die Zeitkonstante des Tiefpasses im Rückkoppelzweig des Differenzverstärkers, wird dieses Aussetzen des Meßvorganges bei einer bestimmten Frequenz des Meßsignals ausgeschlossen.

Das erfindungsgemäße Verfahren ist besonders vorteilhaft bei Anwendung von Sensorelementen, die in eine Sensorelementanordnung wie eine Sensorbrücke bilden können, deren Brückenausgangssignal proportional zum einwirkenden Magnetfeld oder zum einwirkenden Magnetfeldgradienten ist, wenn die Sensorbrücken auf dem jeweiligen Chip bereits integriert Dünnschichtleitungen für den Strom zur Magnetisierung und für den Kompensationsstrom enthalten. Solche Sensoren werden beispielsweise in den Patentschriften US 5, 247, 278 und US 5, 521, 501 beschrieben. Die Dünnschichtleitungen, die hier anstelle der Spulen zur Erzeugung der entsprechenden Magnetfelder dienen, haben wesentlich geringere Induktivitäten als die kompakten Spulen. So sind hier kürzere Ummagnetisierungsimpulse und kleinere Regelzeitkonstanten für die Kompensation des zu messenden Magnetfeldes realisierbar. Damit wird die Bandbreite der Signalverarbeitung besonders groß.

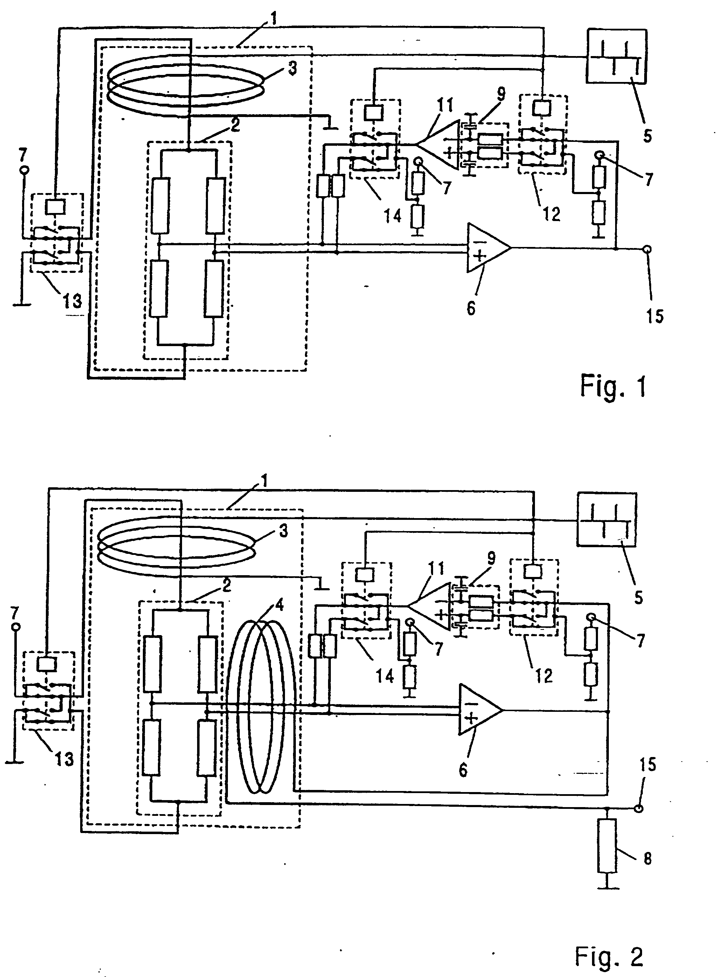

Die Erfindung wird im folgenden an Ausführungsbeispielen näher erläutert. In der zugehörigen Zeichnung ist in Figur 1 eine Anordnung zur Durchführung des Verfahrens unter Verwendung einer magnetoresistiven Sensorbrücke und einer Magnetisierungsspule und in Figur 2 eine Anordnung zur Durchführung des Verfahrens unter Verwendung einer magnetoresistiven Sensorbrücke und einer Magnetisierungsspule sowie einer

Kompensationsspule dargestellt.

In Fig. 1 ist eine magnetoresistive Sensorbrücke (2) enthalten. Deren Betriebsspannung (7) wird durch einen Umschalter (13) im gleichen Takt umgeschaltet, wie in eine Ummagnetisierungsspule (3) aus einem Stromimpulsgenerator (5) Stromimpulse abwechselnder Polarität eingespeist werden. Sensorbrücke (2) und Ummagnetisierungsspule (3) sind integriert auf einem Chip (1) angeordnet. Durch die Umschaltung der Betriebsspannung (7) in der Sensorbrücke (2) wird die Offsetspannung am Brückenausgang zur Wechselspannung. Die Impulse des Stromimpulsgenerators (5) erzeugen in der Ummagnetisierungsspule (3) Magnetfeldimpulse, die auf die die Widerstände der Sensorbrücke (2) bildenden magnetoresistiven Sensorelemente, die als in Dünnschichttechnik aufgebrachte Schichtstreifen ausgeführt sind, einwirken. Die Magnetfeldimpulse sind von ausreichender Feldstärke, um die magnetoresistiven Schichtstreifen in der entsprechenden Richtung zu magnetisieren. Die magnetoresistiven Schichtstreifen sind mit Barberpolstrukturen versehen, ohne daß das in der Zeichnung dargestellt ist. Durch die gleichzeitige Richtungsumkehr oder Modulation der Magnetisierung in den Schichtstreifen und der Brückenbestriebsspannung bleibt die Steigung der Kennlinie der Sensorbrücke erhalten. Wirkt ein Magnetfeld auf die Sensorbrücke (2), so entsteht am Brückenausgang also eine dem Magnetfeld proportionale Gleichspannung, die der durch die Offsetspannung der Sensorbrücke (2) bedingten Wechselspannung überlagert ist.

Dieses Signal wird durch den Differenzverstärker (6) verstärkt. Das verstärkte Signal wird dem ebenfalls im Takt des Stromimpulsgenerators (5) gesteuerten Umschalter oder Modulator (12) zugeleitet. Der zweite Eingang des Umschalters oder Modulators (12) liegt am Ausgang eines Spannungsteilers mit zwei gleichen Widerständen bei der halben Betriebsspannung (7). Nach dem Umschalter (12) ist ein Signal vorhanden, das einen der Offsetspannung proportionalen Gleichanteil und einen zum Magnetfeld proportionalen Wechselanteil enthält. Der Wechselanteil wird in dem Tiefpaß (9), der eine Zeitkonstante hat, die groß gegen den Impulsabstand des Stromimpulsgenerators (5) ist, herausgefiltert. Am Ausgang des Verstärkers (11) ist damit eine zur Offsetspannung der Sensorbrücke proportionale Spannung vorhanden. Durch den gesteuerten Umschalter oder Modulator (14) wird diese Spannung so in den Eingang des Differenzverstärkers (6) eingespeist, daß sie der dort vorhandenen Offsetspannung entgegenwirkt. Durch diese Gegenkopplung wird der Offsetanteil im Signal minimiert oder gar auf Null geregelt, so daß am Ausgang (15) der Schaltung nur noch die zum auf die Sensorbrücke (2) einwirkenden Magnetfeld proportionale Spannung vorhanden ist. Im eigentlichen Signalweg der Schaltung zwischen Sensorbrücke (2) und Ausgang (15) befindet sich als frequenzbegrenzendes Bauelement nur der Differenzverstärker (6). Damit können die Änderungen der Ausgangsspannung den sie hervorrufenden Magnetfeldänderungen mit hoher Geschwindigkeit folgen. Die übertragbare Bandbreite wird nicht durch die Frequenz der Impulse des Stromimpulsgenerators begrenzt, sondern entweder durch die Bandbreite des Differenzverstärkers (6) oder dadurch, daß für die Ummagnetisierung der magnetoresistiven Schichtstreifen eine bestimmte Zeitdauer erforderlich ist. Während dieser Zeitdauer ist die Proportionalität zwischen dem einwirkenden Magnetfeld und der Ausgangsspannung der Sensorbrücke nicht gegeben. Für diese Zeitdauer wurden durch Messungen Werte ermittelt, die deutlich unterhalb einer Mikrosekunde liegen.

Bei diesem Ausführungsbeispiel sind folgende Parameter besonders vorteilhaft: Für die Ummagnetisierung werden Impulse abwechselnder Polarität mit einer Länge von 0,5 µs benutzt. Die Impulsfolgefrequenz wird zwischen 1 kHz und 2 kHz gewobbelt, und zwar mit einer Wobbelfrequenz von 50 Hz. Der Differenzverstärker (6) hat eine Grenzfrequenz von 1 MHz, die Zeitkonstante des Tiefpasses (9) liegt bei 1 s. Damit können Magnetfelder mit einer Bandbreite von 1 MHz in proportionale Ausgangsspannungen umgesetzt werden. Durch die periodische Änderung der Frequenz der Ummagnetisierungsimpulse wird vermieden, daß eine Übereinstimmung zwischen der Frequenz und der Phase der Ummagnetisierungsimpulse mit einer möglichen Frequenz und Phase des zu messenden Magnetfeldes über längere Zeit besteht. Durch die im Vergleich zur Wobbelschwingungsdauer große Zeitkonstante des Tiefpasses (9) werden so aus dem auf den Eingang des Differenzverstärkers (6) zurückgekoppelten Signal alle Anteile herausgemittelt, die vom Magnetfeld verursacht werden. Damit wird hier nur die Offsetspannung aufgehoben, und das Signal am Schaltungsausgang (15) enthält alle Frequenzanteile des Magnetfeldes bis zur Grenzfrequenz.

Fig. 2 zeigt eine Anordnung zur Durchführung des Verfahrens, die in großen Teilen mit der Anordnung von Fig. 1 übereinstimmt. Gleiche Elemente wurden deshalb mit gleichen Nummern versehen. Auf dem Sensorchip (1) ist hier neben der Sensorbrücke (2) und der Ummagnetisierungsspule (3) noch eine Kompensationsspule (4) integriert. Dabei ist zu bemerken, daß weder die Ummagnetisierungsspule (3) noch die Kompensationsspule 4 die Form einer konventionellen Spule haben müssen. Vielmehr werden oft Anordnungen von Dünnschichtleitungen bevorzugt, in deren Nähe bei Stromdurchfluß geeignete Magnetfelder für die Ummagnetisierung der magnetoresistiven Schichtstreifen beziehungsweise zum Aufheben des zu messenden Magnetfeldgradienten entstehen. Der Magnetfeldgradient oder das Magnetfeld in diesem Ausführungsbeispiel wird durch einen Strom erzeugt, dessen Wert mit Hilfe des Verfahrens potentialfrei ermittelt werden soll. Der Flipstromimpulsgenerator (5) liefert gleichzeitig Stromimpulse für die Ummagnetisierungsspule (3) und für den Umschalter (13), der die Betriebsspannung der Sensorbrücke (2) umpolt. Fließt in der Nähe der Sensorbrücke (2) der zu messende Strom, so erzeugt er dort einen Magnetfeldgradienten, und am Ausgang der Sensorbrücke (2) entsteht eine zu diesem Gradienten proportionale Gleichspannung, die von einem Wechselanteil überlagert ist, der durch den Nulloffset der Sensorbrücke (2) bedingt ist. Der zum Offset proportionale Wechselanteil wird wie im ersten Ausführungsbeispiel beschrieben durch die Rückkopplung über den Differenzverstärker (6) minimiert, theoretisch sogar auf Null geregelt. Der Differenzverstärker (6) erzeugt an seinem Ausgang so einen zum zu messenden Strom proportionalen Ausgangsstrom.

Dieser wird in die Kompensationsspule eingespeist und erzeugt dort ein Magnetfeld, das den von dem zu messenden Strom erzeugten Magnetfeldgradienten am Ort der Sensorbrücke gerade aufhebt. Am Ausgang (15) der Schaltung entsteht über dem Widerstand (8) eine zum Kompensationsstrom und damit zum zu messenden Strom proportionale Spannung. Da die magnetoresistive Sensorbrücke (2) hier nur als Nulldetektor für die Kompensation wirkt, spielt die Nichtlinearität, die Temperaturabhängigkeit und die Magnetfeldabhängigkeit der Sensorkennlinie keine Rolle. Die Bandbreite, mit der die Spannung am Ausgang (15) der Schaltung den Änderungen des zu messenden Stromes folgen kann, wird durch die Zeitkonstante des Kompensationsregelkreises bestimmt. Bei Verwendung vorhandener Differenzverstärker und auf dem Chip integrierter, induktionsarmer Kompensationsspulen 4 in Dünnschichtausführung liegt die Bandbreite im Megahertzbereich, während die Frequenz des Stromimpulsgenerators wenige Kilohertz beträgt.

### Bezugszeichenliste:

- 1: Chip
- 2: magnetoresistive Sensorelementanordnung, beispielsweise Sensorbrücke
- 3: Magnetisierungsspule beziehungsweise Ummagnetisierungspule
- 4: Kompensationsleiter oder -spule
- 5: Stromimpulsgenerator
- 6: Differenzverstärker
- 7: Betriebsspannung insbesondere einer Sensorbrücke
- 8: Shuntwiderstand
- 9: Tiefpaß
- 10: Stromleiter
- 11: Verstärker
- 12: Umschalter oder Modulator
- 13: Umschalter oder Modulator
- 14: Umschalter oder Modulator
- 15: Ausgang

## Patentansprüche

1. Verfahren zur Signalauswertung mit Eliminierung eines zum Nulloffset proportionalen Störsignales an magnetoresistiven Sensoren, bei denen die Magnetisierungsrichtungen in den magnetoresistiven Elementen mit Barber Pole Struktur durch Anlegen eines magnetischen Impulsfeldes wechselnder Richtung umgeschaltet werden und die Ausgangsspannung des Sensors (2) einem Differenzverstärker (6) zugeführt wird,
**dadurch gekennzeichnet,**
**daß** die Betriebsspannung (7) des Sensors (2) im Takt des magnetischen Impulsfeldes umgepolt wird,
und **daß** die Ausgangsspannung des Sensors (2) von dem Differenzverstärker (6) verstärkt und über einen im Takt des magnetischen Impulsfeldes gesteuerten Umschalter (12) auf einen Tiefpaß (9) und von dessen Ausgang über einen Verstärker (11) und einen zweiten im Takt des magnetischen Impulsfeldes gesteuerten Umschalter (14) phasenrichtig auf den Eingang des Differenzverstärkers (6) zurückgekoppelt und so der durch den Offsetanteil des Ausgangssignals des Sensors (2) bedingte Wechselanteil am Ausgang des Differenzverstärkers (6) auf Null geregelt wird.

2. Verfahren nach Anspruch 1, **dadurch gekennzeichnet, daß** ein dem Ausgangssignal des Differenzverstärkers (6) proportionaler Strom in einen in der Nähe der Sensorbrücke befindlichen Kompensationsleiter oder eine Kompensationsspule (4) eingespeist und so das zu messende Magnetfeld des Eingangssignales am Ort der Sensorelemente auf Null geregelt wird.

3. Verfahren nach Anpruch 2, **dadurch gekennzeichnet, daß** der durch den Kompensationsleiter oder die Kompensationsspule (4) fließende Kompensationsstrom direkt als Ausgangssignal der Schaltung verwendet wird.

4. Verfahren nach Anpruch 3, **dadurch gekennzeichnet, daß** der Spannungsabfall, den der Kompensationsstrom über einen mit dem Kompensationsleiter oder der Kompensationsspule (4) in Reihe geschalteten Widerstand (8) erzeugt, als Ausgangssignal der Schaltung benutzt wird.

5. Verfahren nach Anspruch 1, **dadurch gekennzeichnet, daß** die Taktfrequenz, mit der die Ummagnetisierung der magnetoresistiven Schichtstreifen erfolgt und mit der die Umschalter (12, 13, 14) gesteuert werden, zeitlich periodisch variiert wird.

6. Verfahren nach Anspruch 1, **dadurch gekennzeichnet, daß** eine magnetoresistive Sensorbrücke (2) zur Messung benutzt wird, deren Ausgangsspannung zum angelegten Magnetfeld proportional ist.

7. Verfahren nach Anspruch 1, **dadurch gekennzeichnet, daß** eine magnetoresistive Sensorbrücke (2) zur Messung benutzt wird, deren Ausgangsspannung zu einem angelegten Magnetfeldgradienten proportional ist.

8. Verfahren nach Anspruch 1, **dadurch gekennzeichnet, daß** das zu messende Magnetfeld oder der zu messende Magnetfeldgradient durch einen Strom erzeugt wird.

9. Vorrichtung umfassend Mittel zur Durchführung des Verfahrens nach Anspruch 1, wobei magnetoresistive Sensorbrücken (2) verwendet werden, die integriert Vorrichtungen zur Erzeugung des Ummagnetisierungsfeldes enthalten.

10. Vorrichtung umfassend Mittel zur Durchführung des Verfahrens nach Anspruch 1, wobei magnetoresistive Sensorbrücken (2) verwendet werden, die integriert Vorrichtungen zur Erzeugung des Kompensationsfeldes enthalten.

11. Vorrichtung umfassend Mittel zur Durchführung des Verfahrens nach Anspruch 1, wobei die Elektronik ganz oder teilweise auf einem Chip als ASIC (= Application Specific Integrated Circuit = anwendungsspezifischer integrierter Schaltkreis) integriert ist.

12. Vorrichtung zur Durchführung des Verfahrens nach Anspruch 11, **dadurch gekennzeichnet, daß** der magnetoresistive Sensor auf demselben Chip integriert ist.

## Claims

1. A method of evaluating signals with elimination of an interference signal proportional to the zero offset on magnetoresistive sensors. in which the magnetization directions in the magnetoresistive elements with a barber's pole structure are changed over by the application of a magnetic pulse field of changing direction and the output voltage of the sensor (2) is supplied to a differential amplifier (6). **characterized in that** the operating voltage (7) of the sensor (2) has its pole reversed in the cycle of the magnetic pulse field, and the output voltage of the sensor (2) is amplified by the differential amplifier (6) and is coupled back to a low-pass filter (9) by way of a change-over switch (12) controlled in the cycle of the magnetic pulse field and from the output of the low-pass filter (9) to the input of the differential amplifier (6) in the correct phase by way of an amplifier (11) and a second change-over switch (14) controlled in the cycle of the magnetic pulse field. and in this way the changed proportion resulting from the offset proportion of the output signal of the sensor (2) is regulated to zero at the output of the differential amplifier (6).

2. A method according to Claim 1, **characterized in that** a current proportional to the output signal of the differential amplifier (6) is fed into a compensating conductor present in the vicinity of the sensor bridge or a compensating coil (4). and in this way the magnetic field - to be measured - of the input signal is regulated to zero at the site of the sensor elements.

3. A method according to Claim 2, **characterized in that** the compensating current flowing through the compensating conductor or the compensating coil (4) is used directly as an output signal of the circuit.

4. A method according to Claim 3, **characterized in that** the voltage drop. which is produced by the compensating current by way of a resistor (8) connected in series to the compensating conductor or the compensating coil (4), is used as an output signal of the circuit.

5. A method according to Claim 1, **characterized in that** the clock frequency, by which the reversal of magnetization of the magnetoresistive layer stripes takes place and by which the change-over switch (12, 13, 14) is controlled, is periodically varied in time.

6. A method according to Claim 1, **characterized in that** a magnetoresistive sensor bridge (2) is used for measurement, the output voltage of which is proportional to the applied magnetic field.

7. A method according to Claim 1, **characterized in that** a magnetoresistive sensor bridge (2) is used for measurement, the output voltage of which is proportional to an applied magnetic-field gradient.

8. A method according to Claim 1, **characterized in that** the magnetic field to be measured or the magnetic-field gradient to be measured is generated by a current.

9. A device comprising means for performing the method according to Claim 1, wherein magnetoresistive sensor bridges (2) are used which contain in an integrated manner devices for generating the magnetization-reversal field.

10. A device comprising means for performing the method according to Claim 1, wherein magnetoresistive sensor hridges (2) are used which contain in an integrated manner devices for generating the compensating field.

11. A device comprising means for performing the method according to Claim 1, wherein the electronic device is integrated entirely or in part as an ASIC (= application-specific integrated circuit) on a chip.

12. A device for performing the method according to Claim 11, **characterized in that** the magnetoresistive sensor is integrated on the same chip.

## Revendications

1. Procédé pour l'évaluation de signaux avec élimination d'un signal parasite proportionnel au décalage du zéro sur des détecteurs magnétorésistifs, où le sens de l'aimantation dans les éléments magnétorésistifs munis d'une structure hélicoïdale est inversée grâce à la mise en place d'un champ d'impulsions magnétique de sens variable et où la tension de sortie du détecteur (2) est amenée vers un amplificateur de différence (6), **caractérisé en ce que** la polarité de la tension de fonctionnement (7) du détecteur (2) est inversée pendant le cycle du champ d'impulsions magnétique et **en ce que** la tension de sortie du détecteur (2) est amplifiée par l'amplificateur de différence (6) et qu'elle est réinjectée, par l'intermédiaire d'un commutateur (12) commandé pendant le cycle du champ d'impulsions magnétique, vers le filtre passe-bas (9) et à partir de la sortie de ce filtre vers un amplificateur (11) et, par l'intermédiaire d'un deuxième commutateur (14) commandé pendant le cycle du champ d'impulsions magnétique, correctement en phase, vers l'entrée de l'amplificateur de différence (6) et ainsi, que la partie variable, conditionnée par la partie de décalage du signal de sortie du détecteur (2), est réglée sur zéro à la sortie de l'amplificateur de différence (6).

2. Procédé selon la revendication 1, **caractérisé en ce qu'**un courant proportionnel au signal de sortie de l'amplificateur de différence (6) est injecté dans un conducteur de compensation ou dans une bobine de compensation (4) se trouvant à proximité du pont de détecteurs et qu'ainsi, le champ magnétique à mesurer du signal d'entrée à l'emplacement des éléments détecteurs est réglé sur zéro.

3. Procédé selon la revendication 2, **caractérisé en ce que** le courant de compensation circulant dans le conducteur de compensation ou dans la bobine de compensation (4) est utilisé directement comme signal de sortie du circuit.

4. Procédé selon la revendication 3, **caractérisé en ce que** la chute de tension, générée par le courant de compensation sur une résistance (8) montée en série avec le conducteur de compensation ou la bobine de compensation(4), est utilisée comme signal de sortie du circuit.

5. Procédé selon la revendication 1, **caractérisé en ce que** la fréquence d'horloge à laquelle est effectuée la désaimantation des bandes stratifiées magnétorésistives et à laquelle sont commandés les commutateurs (12, 13, 14) varie périodiquement dans le temps.

6. Procédé selon la revendication 1, **caractérisé en ce qu'**un pont de détecteurs magnétorésistif (2) dont la tension de sortie est proportionnelle au champ magnétique appliqué, est utilisé pour la mesure.

7. Procédé selon la revendication 1, **caractérisé en ce qu'**un pont de détecteurs magnétorésistif (2) dont la tension de sortie est proportionnelle à un gradient du champ magnétique appliqué, est utilisé pour la mesure.

8. Procédé selon la revendication 1, **caractérisé en ce que** le champ magnétique à mesurer ou le gradient du champ magnétique à mesurer est généré par un courant.

9. Appareil destiné à la réalisation du procédé selon la revendication 1, dans lequel des ponts de détecteurs magnétorésistifs (2) comprenant des appareils intégrés, destinés à la génération du champ de désaimantation, sont utilisés.

10. Appareil destiné à la réalisation du procédé selon la revendication 1, dans lequel des ponts de détecteurs magnétorésistifs (2) comprenant des appareils intégrés, destinés à la génération du champ de compensation, sont utilisés.

11. Appareil destiné à la réalisation du procédé selon la revendication 1, dans lequel l'électronique est intégrée entièrement ou en partie sur une puce en tant qu'ASIC (Application Specific Integrated Circuit : circuit intégré spécifique à l'application).

12. Appareil destiné à la réalisation du procédé selon la revendication 11, **caractérisé en ce que** le détecteur magnétorésistif est intégré sur la même puce.
